**Europäisches Patentamt**

**European Patent Office**

**Office européen des brevets**

(11) Veröffentlichungsnummer: **0 141 305**
**A2**

(12) **EUROPÄISCHE PATENTANMELDUNG**

(21) Anmeldenummer: **84112075.1**

(22) Anmeldetag: **09.10.84**

(51) Int. Cl.⁴: **H 01 R 13/629**

(30) Priorität: **26.10.83 DE 3338770**

(43) Veröffentlichungstag der Anmeldung:
**15.05.85 Patentblatt 85/20**

(84) Benannte Vertragsstaaten:
**AT CH DE FR GB IT LI SE**

(71) Anmelder: **Hackner, Hans**
**Wappersdorf 35**
**D-8431 Mühlhausen(DE)**

(72) Erfinder: **Hackner, Hans**
**Wappersdorf 35**
**D-8431 Mühlhausen(DE)**

(74) Vertreter: **Neubauer, Hans-Jürgen, Dipl.-Phys.**
**Fauststrasse 30**
**D-8070 Ingolstadt(DE)**

(54) **Halte- und Abtastvorrichtung für einen elektrischen Stecker.**

(57) Die Erfindung betrifft eine Halte- und Abtasteinrichtung für einen elektrischen Stecker, insbesondere für die Prüfung von Kabelbäumen. Für die elektrische Prüfung von Steckern (2) werden die metallischen Steckhülsen (12) von federnden Kontaktstiften (16) elektrisch abgetastet. Dazu müssen die Stecker (2) sicher und fest während der Messung am Kontaktstift (16) gehalten werden. Erfindungsgemäß ist hierfür ein Federbügel (9) vorgesehen, der zwei Schenkel (20,21) mit jeweils einem konischen Bereich (23) aufweist. Die Schenkelenden sind mit Spitzen (22) versehen im Bereich einer Aussparung (14) für den Stecker (2) in einer Grundplatte (3). Der Federbügel (9) ist durch einen pneumatischen Antrieb (6) in der Einführrichtung des Steckers (2) bewegbar. Durch die konische Anlenkung der Federschenkel (20, 21) wird der Stecker (2) mit den Spitzen (22) ergriffen und bis zum Anschlag in die Aussparung (14) eingezogen. Die Bewegung des Federbügels (9) wird bereits ausgelöst, wenn der Stecker (2) teilweise eingeschoben und eine Abtastplatte (30) bewegt wurde. Wegen der definierten Einzugstellung des Steckers (2) bis zum Anschlag wird eine sichere Kontaktgabe zum Kontaktstift (17) erreicht, die zu sicheren Meßergebnissen führt. Nach Betätigung einer Drucktaste (35) wird der Federbügel (20) wieder in seine Ausgangslage geführt und der Stecker (2) ausgeworfen.

./...

EP 0 141 305 A2

FIG.1

PATENTANWALT
DIPL.-PHYS. HANS-J. NEUBAUER **0141305**
EUROPEAN PATENT ATTORNEY

-1-

Herr

Hans Hackner

Wappersdorf Nr. 35

8431 Mühlhausen/Opf.

Fauststraße 30
D-8070 Ingolstadt

Telefon (08 41) 7 24 12
Telegramm neupat Ingolstadt
Telex 5 5809 nepa d

P 59HA 84/54

## Halte- und Abtastvorrichtung für einen elekrischen Stecker

Die Erfindung betrifft eine Halte- und Abtastvorrichtung für einen elektrischen Stecker, insbesondere für die Prüfung von Kabelbäumen, gemäß dem Oberbegriff des Anspruchs 1.

Kabelbäume für Kraftfahrzeuge werden so hergestellt, daß elektrische Leitungen in der gewünschten Länge abgeschnitten und zu Strängen und Bäumen gewickelt und gebunden werden. Anschließend werden die Enden abisoliert und mit Steckern versehen. Die so hergestellten Kabelbäume werden in der Serienfertigung in Kraftfahrzeuge eingebaut und sind beim fertig montierten Fahrzeug durch eine Reihe von weiteren Bauteilen und Abdeckelementen verdeckt und weitgehend unzugänglich. Eine nachträgliche Arbeit oder Reparatur an einem defekten Kabelbaum bei einem fertig montierten Fahrzeug ist daher äußerst aufwendig. Um Fehler in den Kabelbäumen weitestgehend auszuschließen, werden diese daher nach ihrer Fertigstellung einer eingehenden Prüfung auf elektrischen Durchgang, Leitfähigkeit, mögliche Wackelkontakte, etc. unterzogen. Dazu ist es erforderlich, elektrische Meßgeräte bzw. Meßcomputer über elektrische Kontakte mit den einzelnen Steckern eines Kabelbaums zu verbinden. Eine solche Verbindung soll wegen der Vielzahl der zu prüfenden Kabelbäume und der Vielzahl der Stecker möglichst schnell durchgeführt werden können und dennoch zu einem sicheren Kontakt mit der Meßeinrichtung führen, so daß ein sicheres Meß- und Kontrollergebnis zur Verfügung steht. Eine weitere Forderung besteht darin, daß die Vorrichtung, in die die Stecker eines Kabelbaums für die Prüfung eingesteckt werden sollen, flächenmäßig relativ klein ist, da bei einem fertigen und ausgebundenen Kabelbaum die freien Kabelenden nicht beliebig lang sind, d. h. die einzelnen Stecker nicht beliebig weit voneinander eingesteckt werden können.

Es ist eine Prüfeinrichtung für Kabelbäume bekannt (in der Praxis eingesetzte Ausführung gemäß DE-OS 32 38 949), bei der in einem pultartigen Rasterfeld einzelne Halte- und Abtasteinrichtungen für jeweils einen Stecker eines Kabelbaumes angebracht sind. Eine solche Halte- und Abtasteinrichtung besteht aus einer in das Rastermaß passenden Grundplatte mit einer darin enthaltenen Aussparung entsprechend der Steckerform und mit wenigstens einem federnden Abtaststift in der Aussparung, der beim Einstecken des Steckers mit der metallischen Steckhülse Kontakt erhält. Wenn mehrere Steckhülsen in einem Vielfachstecker enthalten sind, sind entsprechend mehrere Federstifte vorgesehen. Der oder die Federstifte sind elektrisch mit den Meßinstrumenten oder dem Meßcomputer verbunden, der beispielsweise einen fehlenden elektrischen Durchgang eines defekten Kabels oder einer defekten Steckverbindung anzeigt.

Die Steckerhülsen werden somit nicht wie bei der endgültigen Montage im Kraftfahrzeug auf Flachstecker aufgesteckt, da dies zu aufwendig und zeitraubend wäre, sondern lediglich durch Taststifte elektrisch abgetastet. Daher ist die Steckverbindung bei der Prüfung locker und unsicher. Die Steckergehäuse aus Kunststoff sind nämlich nur mit großen Maßtoleranzen hergestellt, so daß diese oft nur sehr locker in den Steckeraussparungen sitzen. Weiter zieht das Gewicht der meist schweren Kabelbäume an den Steckern und versucht, diese abzuziehen, wobei diese Kraft noch durch die in Abziehrichtung der Stecker wirkende Schubkraft der federnden Kontaktstifte verstärkt wird. Um hier eine Verbesserung zu schaffen, werden die Stecker im eingesteckten Zustand durch eine Vorrichtung gehalten. Die Vorrichtung ist so aufgebaut, daß eine elektrische Spule mit einem als Haltestift ausgebildeten Spulenkern vorgesehen ist. Wenn ein Stecker in eine Halte- und Abtasteinrichtung eingeführt wird, schaltet er einen in der Steckeraussparung angebrachten Mikroschalter. Über diesen Mikroschalter wird die Magnetspule angesteuert und unter Strom gesetzt. Dadurch wird der Haltestift seitlich, etwa im rechten Winkel zu der Einsteckrichtung, auf den Stecker zubewegt. Der Haltestift stützt sich dann an einer Steckerseitenwand ab und drückt diesen gegen die gegenüberliegende Seitenwand der Aussparung. Nach der Messung wird der Strom zu der Magnetspule von Hand wieder abgeschaltet und der Stecker kann herausgezogen werden.

Diese Haltevorrichtung führt im praktischen Betrieb regelmäßig zu Problemen und unsicheren Messungen. Da der Mikroschalter zur Abtastung der Steckerposition einen bestimmten Auslöse- oder Schaltweg benötigt, muß dieser so angebracht sein, daß er bereits auslöst, bevor der Stecker bis zum Anschlag eingeschoben ist. Damit fährt auch der Haltestift normalerweise bereits aus, bevor noch der Stecker bis zum Anschlag eingeschoben ist, so daß die Stecker teilweise verkantet gehalten werden. Wegen der oben genannten Fertigungstoleranzen der Steckergehäuse ist es ohnehin möglich, daß die Stecker zum Teil verkantet von der Bedienperson eingesteckt werden und dadurch der Mikroschalter schon vor einer Kontaktgabe schaltet und durch den Haltestift die Einsteckbewegung unterbrochen wird. Da der Haltestift einseitig auf die Steckerwand trifft, wird dieser und damit die darin enthaltene Steckhülse von seiner mittleren Position in Richtung auf die gegenüberliegende Aussparungswand gedrängt, so daß auch dadurch entweder eine Kontaktgabe völlig fehlt oder durch eine unzureichende Kontaktgabe ein hoher Leitungswiderstand im Kabelbaum vorgetäuscht wird. In der Praxis ist es dann notwendig, die Stecker mit fehlender oder schlechter Kontaktgabe in den Aussparungen hin- und herzubewegen bzw. wieder neu einzustecken, wobei die Gefahr besteht, daß ein tatsächlich vorhandener schlechter Kontakt oder Wackelkontakt durch die Kabelbewegung im Stecker nur für die Zeit der Messung behoben wird und damit ein tatsächlicher Fehler nicht erkannt wird. Weiter ist als nachteilig anzusehen, daß in unmittelbarer Nähe der Kontaktstellen weitere elektrische Elemente, wie die Magnetspule und der Mikroschalter, angebracht sind, da auch hierüber durch Kriechströme, schlechte Isolation, Magnetfeldeinstrahlung, etc. eine Verfälschung der Messungen, zumindest bei einem möglichen Defekt in der gesamten Anordnung, nicht auszuschließen ist.

Aufgabe der Erfindung ist es demgegenüber, eine Halte- und Abtasteinrichtung zu schaffen, die einen Stecker mit größerer Sicherheit in der gewünschten Position für eine gute Kontaktgabe hält.

Diese Aufgabe wird bei einer gattungsgemäßen Halte- und Abtasteinrichtung mit den kennzeichnenden Merkmalen des Anspruchs 1 gelöst.

Gemäß Anspruch 1 ist ein Federbügel mit zwei federnden Schenkeln vorgesehen, die um den mittleren Taststift angebracht sind und deren Schenkel einen konischen Bereich enthalten, der sich an festen Führungen abstützt. Diese Schenkel sind vorzugsweise im Bereich der Aussparung für den Stecker abgebogen und zu Spitzen ausgeformt (Anspruch 2), so daß sich zwei beidseitig auf einen einzuführenden Stecker zu gerichtete Krallen ergeben. Wenn der Federbügel angehoben wird, läuft der konische Schenkelbereich an der festen Führung entlang, wodurch die Schenkelspitzen aufeinander zubewegt werden und den Stecker ergreifen. Wenn nun der Federbügel noch weiter bewegt wird, wird der Stecker nach oben bis zum Anschlag gezogen. Da die Schenkel im Bereich der konischen Führung nicht starr sondern federnd sind, wird dabei die Greifeinrichtung nicht mit zu großer Kraft geschlossen oder die Bewegung des Federbügels insgesamt blockiert. Die festen Führungen für den konischen Bereich der Federschenkel sollten daher auch in einem gewissen Abstand von der Steckeraussparung angebracht sein. Der Federbügel wird durch einen Antrieb bewegt, der von einer Abfühleinrichtung in der Steckeraussparung angesteuert ist. Diese Abfühleinrichtung kann relativ weit vorne am Anfang des Einführweges für den Stecker angebracht sein, da mit der erfindungsgemäßen Vorrichtung durch die Abfühleinrichtung ein automatischer Steckereinzug eingeleitet wird und nicht, wie im Stand der Technik, die manuelle Einführung eines Steckers durch die Halteeinrichtung bei deren Aktivierung gestoppt wird.

Vorteilhaft wird ein Stecker somit nach dem manuellen teilweisen Einführen in die Aussparung der Grundplatte beidseitig sicher erfaßt, und ohne zu verkanten in der Mitte der Aussparung bis zum Anschlag automatisch eingezogen. Dadurch wird der erwünschte feste Halt eines Steckers mit sicherer Kontaktauflage des oder der Federstifte erzielt.

Gemäß Anspruch 3 wird vorgeschlagen, den Antrieb für den Federbügel elektrisch auszuführen. Es kann dazu ein Elektromotor oder vorzugsweise eine schnell arbeitende Magnet-Tauchspulenanordnung verwendet werden. Die Tauchspule wäre aber hier, im Gegensatz zum Stand der Technik, in Einschubrichtung des Steckers anzuordnen. Die Abfühl-

6    0141305

einrichtung könnte, wie im Stand der Technik, ein elektrischer Endschalter sein, wobei allerdings hier die Anordnung und Justierung weitgehend unkritisch ist.

Eine besonders bevorzugte Ausführungsform wird mit den folgenden Ansprüchen erzielt. Nach Anspruch 4 ist als Antrieb eine pneumatische, doppelwirkende Kolben-Zylinder-Einheit vorgesehen. Damit sind an die Halte- und Abtastvorrichtung bzw. an eine Aneinanderreihung mehrerer Vorrichtungen keine elektrischen Ströme mehr geführt, die zu einer Meßverfälschung führen könnten. Dies ist insbesondere dann der Fall, wenn auch die Ansteuerung der Kolben-Zylinder-Einheit pneumatisch erfolgt. Es wäre jedoch auch denkbar, zur Ansteuerung einen elektrischen Mikroschalter zu verwenden, der ein Magnetventil aktiviert, wobei auch hier nur sehr geringe Steuerströme über den Mikroschalter fließen müßten. Ein weiterer Vorteil eines pneumatischen Antriebs besteht darin, daß einfach die Zugkraft durch den Vordruck der Druckluftversorgung eingestellt werden kann.

Mit den Merkmalen des Anspruchs 5 wird eine in der praktischen Erprobung bewährte pneumatische Ansteuerung des Antriebs angegeben. Der Auswurf des Steckers erfolgt hier ebenfalls automatisch nach Betätigung einer Drucktaste eines zweiten Steuerventils. Es versteht sich, daß dieses Steuerventil bzw. die Auswurftaste für mehrere Halte- und Abtastvorrichtungen durch entsprechende Verbindung von Schlauchleitungen zusammengefaßt werden kann.

Mit Anspruch 6 wird ein Steuerventil in der Art eines pneumatischen Endschalters beansprucht, das sehr klein und    einfach aufgebaut ist und preiswert hergestellt werden kann. Dieses Steuerventil kann für eine Vielzahl von Anwendungsfällen unabhängig von der vorliegenden Halte- und Abtastvorrichtung eingesetzt werden.

Die Ansprüche 7 und 8 haben weitere zweckmäßige Ausgestaltungen des Steuerventils zum Inhalt.

Anhand einer Zeichnung wird ein Ausführungsbeispiel des Anmeldungsgegenstandes mit weiteren Einzelheiten, Merkmalen und Vorteilen näher erläutert.

Es zeigen

Fig. 1 eine Halte- und Abtastvorrichtung für einen elektrischen Stecker, teilweise geschnitten, mit einer schematisch dargestellten, pneumatischen Steuereinrichtung in einer Seitenansicht,

Fig. 2 eine Draufsicht auf eine Grundplatte der Halte- und Abtastvorrichtung mit deren Seitenansichten und Klemmverbindungen,

Fig. 3 einen Schnitt durch die Grundplatte im Bereich eines Steuerventils,

Fig. 4 einen Schnitt durch ein zweites Steuerventil im geöffneten Zustand,

Fig. 5 einen Schnitt durch das Steuerventil gemäß Fig. 4 im geschlossenen Zustand.

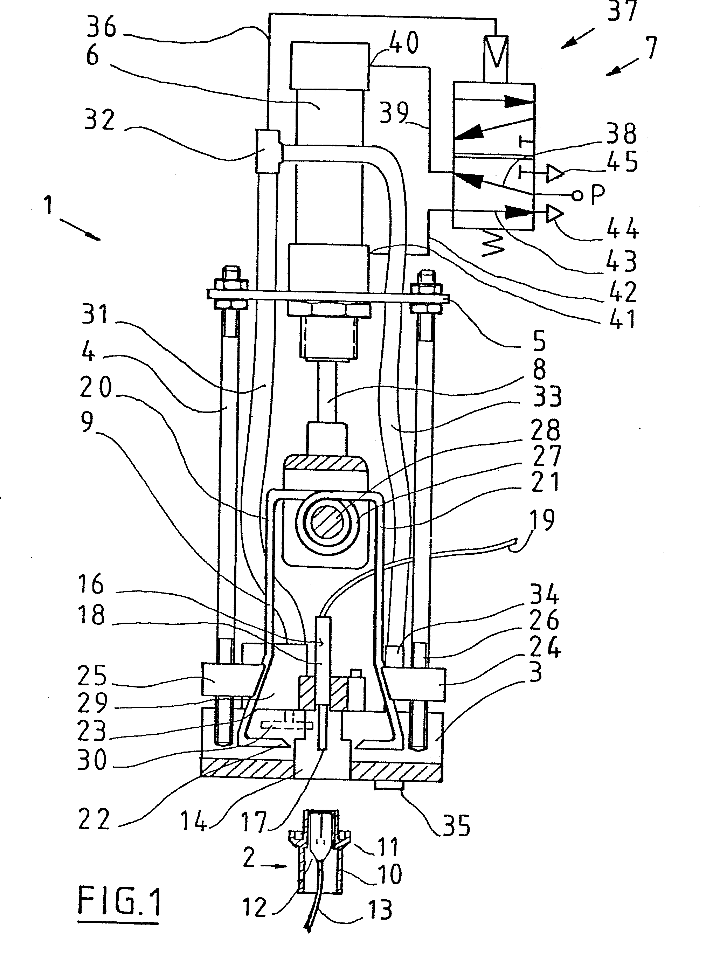

In Fig. 1 ist eine Halte- und Abtastvorrichtung 1 für einen elektrischen Stecker 2 dargestellt, die im wesentlichen aus einer Grundplatte 3 und einer davon im Abstand durch Distanzstäbe 4 gehaltenen Tragplatte 5 besteht, wobei auf der Tragplatte ein doppelwirkender, pneumatischer Kolben 6 mit einer entsprechenden pneumatischen Steuervorrichtung 7 angebracht ist, die Kolbenstange 8 des pneumatischen Kolbens 6 in Richtung auf die Grundplatte 3 weist und mit einem Federbügel 9 verbunden ist.

Der gezeigte Stecker 2 besteht aus einem Kunststoffgehäuse 10 mit einem umlaufenden Bund 11, in dem eine metallische Steckhülse 12 mit einem angeschlagenen Kabel 13 enthalten ist.

In der Grundplatte 3 ist eine Aussparung 14 angebracht, die in ihrer Form dem Vorderteil des Steckergehäuses 10 entspricht und in die der Stecker 2 für den Kabeltest eingeführt wird. In einem mit der Grundplatte 3 verschraubten Block 15 ist ein Federstift 16 gehalten, dessen untere Spitze 17 in die Aussparung 14 ragt und gegen die Kraft einer (nicht dargestellten) Feder in ein oberes, dünnes Rohr 18 zurückgeschoben werden kann. Am Federstift 16 ist ein elektrisches Kabel 19 angelötet, das mit einem Meßgerät für die elektrische Prüfung, bzw. beim Test vieler Kabel in einem Kabelbaum für ein Kraftfahrzeug mit einem Meßcomputer verbunden ist. Beim Einführen des Steckers 2 wird die Federstiftspitze von einer metallischen Steckhülse 12 nach oben gedrückt, so daß diese federnd aufliegt und ein sicherer Kontakt zwischen der Steckhülse 12 und der Federstiftspitze 17 hergestellt ist.

Der Federbügel 9 ist im wesentlichen U-förmig ausgebildet, mit zwei in Richtung auf die Grundplatte 3 weisenden Schenkeln 20, 21, die zu ihrem freien Ende hin konisch nach außen gebogen sind und im Endbereich nach innen abknicken und mit ihren zu Spitzen 22 angeschrägten Enden unmittelbar an der Aussparung 14 enden. Die konischen Bereiche 23 liegen an Führungsklötzen 24, 25 mit einer entsprechenden konischen Schräge an. Die Distanzstäbe 4 sind mit Gewinden 26 in die Grundplatte 3 geschraubt. Diese Gewinde 26 sind nach oben hin verlängert und tragen auch die Führungsklötze 24, 25, d. h. durch Drehen der Führungsklötze 24, 25 kann deren Höhe entlang den Gewinden 26 verstellt und justiert werden. Es ist zu erkennen, daß je nach dieser Einstellung die Spitzen 22 der Federschenkel 20, 21 näher oder weiter auseinanderstehen.

9

0141305

Der Federbügel 9 ist an seiner Oberseite einmal eingerollt. Durch das so gebildete Auge 27 ist eine Achse 28 gesteckt, so daß eine Verbindung des Federbügels 9 mit der Kolbenstange des doppelwirkenden, pneumatischen Kolbens 6 hergestellt ist. In der gezeigten Darstellung ist der Kolben in seiner unteren, d. h. der Grundplatte 3 zugewandten Stellung. Sobald der Stecker 2 in die Aussparung 14 eingeführt wird, soll die Kolbenstange 8 nach oben geführt werden bzw. die pneumatische Ansteuerung des doppelwirkenden Kolbens 6 umgekehrt werden. Dazu ist folgende pneumatische Steuereinrichtung vorgesehen:

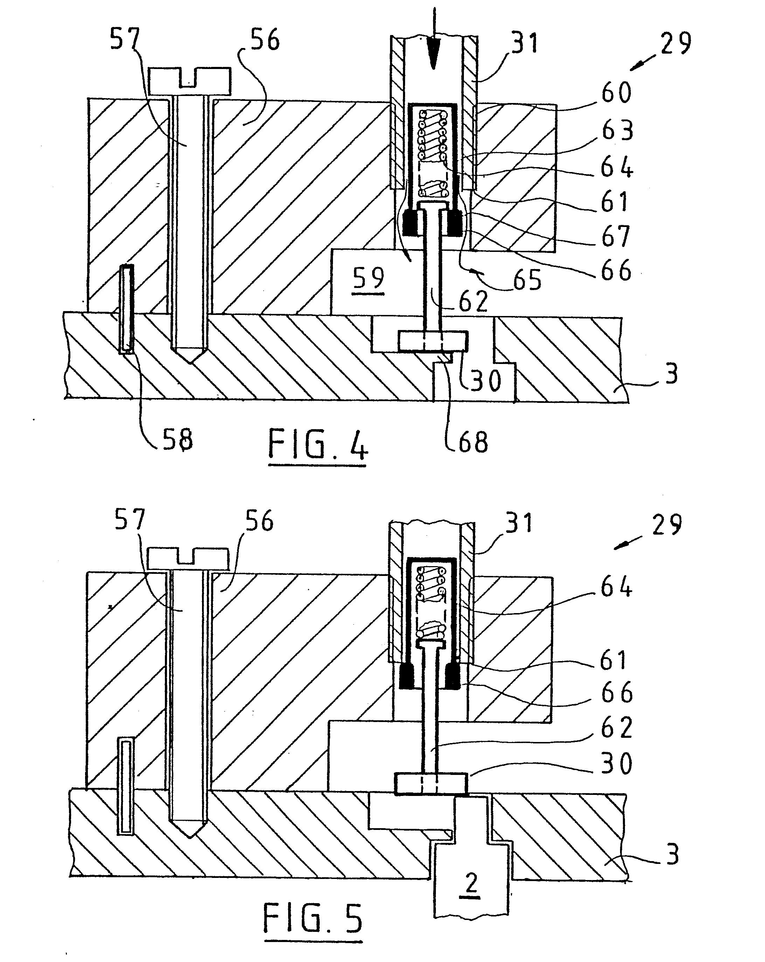

Auf der Grundplatte 3 ist ein erstes Steuerventil 29 befestigt, das als eine Art pneumatischer Endschalter wirkt. Dazu ragt eine Abtastplatte 30 in den Bereich der Aussparung 14, die beim Einführen des Steckers 2 nach oben gedrückt wird. Dadurch wird dann ein geringer Luftstrom, der durch eine pneumatische Schlauchleitung 31 geführt ist, unterbrochen bzw. die Schlauchleitung 31 abgesperrt. Die genaue Ausführung des ersten Steuerventils 29 ist in den Fig. 4 und 5 dargestellt.

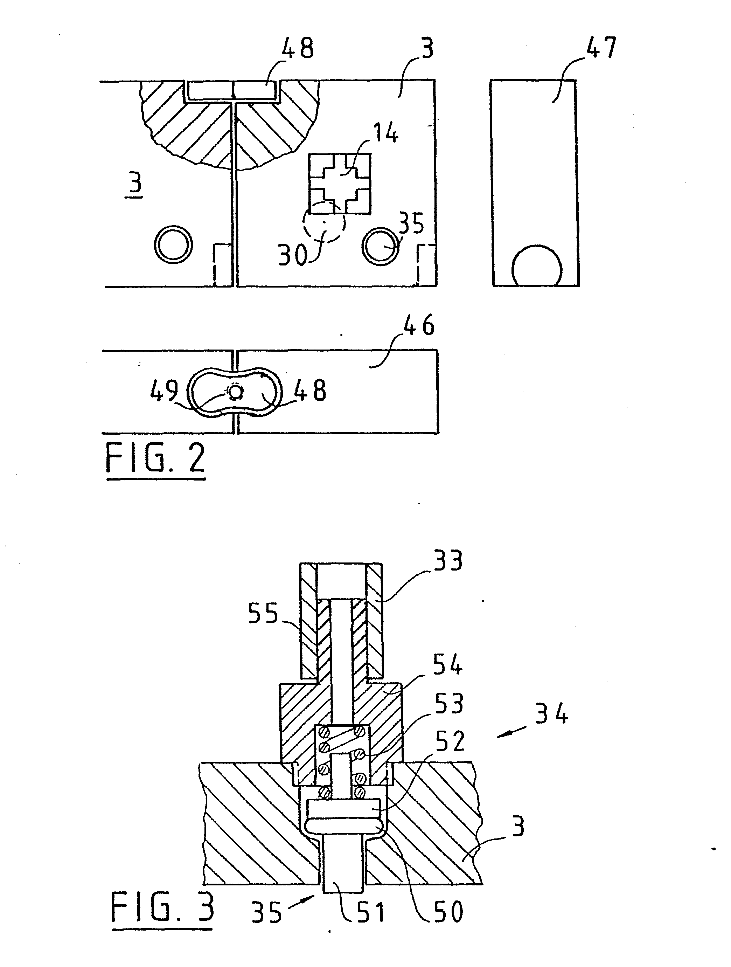

Die Schlauchleitung 39 endet in einem T-Stück 32, von dem eine zweite Schlauchleitung 33 ebenfalls bis an die Grundplatte 3 geführt ist. Dort ist ein zweites, handbetätigtes Steuerventil 34 angebracht. Dieses Steuerventil 34 sperrt normalerweise die Schlauchleitung 33, öffnet diese jedoch bei Betätigung des Druckknopfes 35, so daß hierüber die anstehende Steuerdruckluft entweichen kann. Die detaillierte Ausführung des zweiten Steuerventils 34 ist aus Fig. 3 zu ersehen.

Vom T-Stück 32 führt eine weitere Schlauchleitung 36 zu einem dritten Steuerventil 37 (die Leitungen von und zu diesem Steuerventil 37 sind der Übersichtlichkeit halber in Strichen ausgeführt und das Steuerventil 37 selbst ist nur schematisch gezeigt; das Steuerventil 37 ist jedoch ebenfalls auf der Tragplatte 5 unmittelbar neben der
pneumatischen Kolben-Zylinder-Einheit 6 angebracht).
Wenn in der Leitung 36 kein Druck aufgebaut wird, d. h.
eines der Steuerventile 29 oder 34 offen ist, hat das
Steuerventil 37 den dargestellten Schaltzustand. Dabei
gelangt vom Druckluftanschluß P über den Schaltweg 38
und eine Leitung 39 Druckluft zum oberen Anschluß 40
des pneumatischen Zylinders 6, wodurch der darin enthaltene Kolben nach unten gedrängt wird.

Von einem unteren Anschluß 41 des Zylinders 6 führt eine
Leitung 42 zum Steuerventil 37 und über den darin enthaltenen Schaltweg 43 zur Entlüftungsöffnung 44.

Wenn in der Leitung 36 Druck aufgebaut wird, d. h. beide
Steuerventile 29 und 34 geschlossen sind, steuert das
Steuerventil 37 um, wodurch der Schaltweg 38 mit der
Entlüftungsöffnung 45 verbunden wird und der Schaltweg 43
mit dem Druckluftanschluß P. Dadurch wird der obere Teil
des Zylinders 6 entlüftet und unter den Kolben Druckluft
geführt, wodurch dieser nach oben gedrängt wird.

Die dargestellte Anordnung hat folgende Funktion:
Bei der Prüfung eines Kabelbaumes auf elektrischen Durchgang, die Qualität der Kabel-Steckerverbindungen, Leitfähigkeit, etc., werden die mit Steckern versehenen
Kabelenden an ein Gestell oder Pult herangebracht, in dem
nebeneinander eine den Steckern entsprechende Anzahl von
Halte- und Abtastvorrichtungen gemäß Fig. 1 angebracht
sind. Wie eine hohe Bestückungsdichte und feste Verbindung
zwischen den einzelnen Vorrichtungen erreicht wird, ist
im Zusammenhang mit Fig. 2 näher dargestellt. Von einer
Bedienperson werden dann der Reihe nach die einzelnen
Stecker 2 in die Aussparungen 14 der Grundplatten 3 eingeführt. Beim Einführen eines Steckers 2 wird durch die
metallische  Steckhülse 12 die Federstiftspitze 7 zur
Kontaktgabe berührt und zugleich auch die Abtastplatte 30 des Steuerventils 29. Beim weiteren Einführen des Steckers 2 wird die Abtastplatte 30 in das Ventil 29 eingeschoben und dadurch die Schlauchleitung 31 abgesperrt. Dadurch kann keine Steuerluft aus der Schlauchleitung 31 mehr austreten, und da die Schlauchleitung 33 durch das Steuerventil 34 ebenfalls abgesperrt ist, baut sich in der Leitung 36 ein Druck auf. Das Steuerventil 37 wird dadurch umgesteuert, der obere Teil des Zylinders 6 entlüftet und der untere Teil des Zylinders 6 mit Druck beaufschlagt, so daß der doppelwirkende, pneumatische Kolben nach oben geführt wird. Bei dieser Bewegung gleiten die konischen Bereiche 23 des Federbügels 9 an den Führungsklötzen 24, 25 entlang nach oben. Dabei ist ersichtlich, daß die unteren waagrecht gerichteten Spitzen 22 aufeinander zubewegt werden. Bei dieser Klammer- und Schließbewegung erfassen sie den oberen Teil des Steckergehäuses 10, krallen sich in dessen Kunststoffwände und ziehen den Stecker vollständig in die Aussparung 14 bis zum Anschlag. Die Bedienperson braucht somit nur den Einführvorgang einzuleiten, bis die Abtastplatte 30 etwas angehoben ist. Das Einziehen des Steckers bis zum Anschlag und den Halt des Steckers während der Messung übernimmt die Halte- und Abtastvorrichtung 1 selbsttätig. Der Stecker 2 sitzt somit während der Messung weder verkantet noch locker oder zuwenig weit eingeschoben, so daß bei der Messung keine Fehler durch mangelnde Kontaktgabe mehr auftreten.

Zum Lösen des Steckers wird der Druckknopf 35 betätigt, wodurch das Steuerventil 34 öffnet und der Druck aus der Leitung 36 abgebaut wird. Das Steuerventil 37 steuert dabei um, so daß die Kolbenstange dabei wieder nach unten in die gezeichnete Ausgangsstellung verfahren wird. Der Stecker 2, der in seinem eingezogenen Zustand von den Spitzen 22 gehalten ist, wird dabei mit einem Stoß nach außen automatisch ausgeworfen.

In Fig. 2 ist eine Frontansicht auf zwei nebeneinanderliegende Grundplatten 3 in einem (nicht näher gezeichneten) Pult dargestellt. Die Zeichnung entspricht der Originalgröße mit einer Seitenlänge der quadratischen Grundplatte 3 von 5 cm. Es ist wesentlich, daß die vordere Grundplattenfläche möglichst klein gehalten wird, da bei der Prüfung von Kabelbäumen diese bereits zusammengebunden sind und die freien Enden nur eine begrenzte Länge aufweisen, so daß die daran befestigten Stecker nicht beliebig weit voneinander zu einzelnen Grundplatten 3 geführt werden können. Die gesamte Halte- und Abtastvorrichtung 1 ist somit unter der Forderung der Miniaturisierung zu sehen. Insbesondere wurde daher auch ein Federbügel 9 eingesetzt, der den zentralen Abtastfederstift umgreift, so daß keine größeren Anordnungen seitlich des Abtaststifts erforderlich sind. Bei größeren Mehrfachsteckern, an denen eine Vielzahl von Kabeln angeschlossen sein können, sind größere Grundplatten zu verwenden, die sich jedoch in das Rastermaß 5 cm x 5 cm einfügen sollen. Bei rechteckigen Vielfachsteckern reicht beispielsweise meist ein Rastermaß von 10 cm x 5 cm aus. An der Grundplatte 3 sind dann eine Reihe von Abtastfederstiften 16 angebracht, die mit einem jeweils zugeordneten Steckschuh beim Einführen des Steckers Kontakt haben. Der Federbügel 9 ist auch bei größeren Steckern gleich ausgeführt, lediglich die Federschenkel 20, 21 sind weiter auseinander angeordnet.

Der Federbügel 9 könnte entgegen der dargestellten Ausführungsform nicht aus einem durchgehenden Federdraht gebildet sein, sondern beispielsweise einzelne federnde Schenkel aufweisen. Wesentlich ist nur, daß konische Anlenkflächen vorhanden sind, die bei einer Bewegung des Federbügels 9 nach oben eine Greif- und Zugbewegung auf einen eingeführten Stecker ausüben. Diese Greif- und Zugbewegung soll durch einen Endschalter, im dargestellten Ausführungsbeispiel durch die Abtastplatte 30 ausgeführt, ausgelöst werden, so daß die endgültige Position des Steckers unabhängig von einer zuverlässigen Steckereinfuhr durch eine Bedienperson wird.

Die Ansteuerung und Bewegung des Federbügels 9 ist im gezeigten Ausführungsbeispiel pneumatisch durchgeführt. Eine pneumatische Steuerung hat sich in der Praxis durch ihre Störunanfälligkeit gut bewährt. Weiter war es möglich, sie sehr kompakt aufzubauen. Zusätzlich ist von Vorteil, daß die Greif- und Zugkraft durch den Vordruck in der Druckversorgungsleitung eingestellt werden kann. Die erfindungsgemäße Halte- und Abtastvorrichtung kann jedoch ebenfalls mit äquivalenten elektrischen Mitteln aufgebaut werden. Die Betätigungsstange 8 wäre dann beispielsweise mit der Tauchspule eines Elektromagneten verbunden, der über einen elektrischen Mikro-Endschalter in der Aussparung 14 angesteuert sein könnte. Auch der Auswurf des Steckers nach der Messung könnte über einen Schalter oder Taster an der Frontseite der Grundplatte 3 erfolgen.

Mit den Bezugszeichen 46 und 47 sind die Ansichten der Schmalseiten der Grundplatten 3 in Fig. 2 bezeichnet. Zur stabilen Verbindung der einzelnen Grundplatten 3 in einem Pult oder Gestell sind Verbindungselemente 48 vorgesehen, die in entsprechende, an den Schmalseiten angebrachte Ausnehmungen eingedrückt sind. Diese Verbindungselemente 48 sind aus Kunststoffmaterial und an beiden Seiten etwa kreisförmig gewölbt. Dadurch ergibt sich eine Hinterschneidung, die die Grundplatten 3 zusammenhält. Die Größe der Verbindungselemente ist so gewählt, daß sie in die entsprechenden Ausnehmungen fest eingedrückt werden müssen, dort festsitzen und nicht über die Grundplatten 3 vorstehen. Um die Verbindungselemente 48 wieder bequem herausnehmen zu können und damit die Verbindungen lösen zu können, ist eine Gewindebohrung 49 in der Mitte der Verbindungselemente vorgesehen. Zum Lösen wird hier lediglich eine Schraube eingedreht, wodurch das Verbindungselement 48 aus den Aussparungen herausgedrückt wird. Zum Befestigen der einzelnen Halte- und Abtastvorrichtungen sind jedoch auch marktübliche Einrichtungen, wie Federklammern, etc., möglich.

In Fig. 3 ist das Steuerventil 34 im Schnitt und vergrößert dargestellt. In der Grundplatte 3 ist eine Bohrung angebracht, die zur Frontseite hin enger ist. Der Übergang von der weiteren Öffnung zur engeren Öffnung ist der Ventilsitz für einen Gummirundschnurring 50. Dieser sitzt auf einem Drehteil 51, das nach außen vorsteht und dort den Druckknopf 35 bildet. Der Gummirundschnurring 50 stützt sich an einem Bund 52 ab, der von der anderen Seite her durch eine Feder 53 belastet ist, und so den Gummirundschnurring 50 auf den Ventilsitz drückt. Die Feder 53 stützt sich an einem weiteren Drehteil 54 ab, das in die Grundplatte 3 eingeschraubt ist. Das Drehteil 54 enthält eine zentrale Bohrung und einen Stutzen 55, auf den der Schlauch 33 gesteckt ist. Als Verbindung zum Schlauch 33 könnte auch eine handelsübliche Schnellkupplung verwendet sein.

Das gezeigte Ventil 54 hat folgende Funktion: Durch die Kraft der Feder 53 schließt der Gummirundschnurring 50 das Ventil und es kann keine in der Leitung 33 anstehende Druckluft nach außen entweichen. Wenn der Druckknopf 35 gegen die Kraft der Feder 53 betätigt wird, hebt der Gummirundschnurring 50 vom Ventilsitz ab und es kann Druckluft aus dem Schlauch 33 durch den nicht dichten Spalt zwischen dem Drehteil 51 und der unteren Führungsbohrung in der Grundplatte 3 zur Frontseite hin austreten, so daß der Druck in der Schlauchleitung 33 abgebaut wird und das Steuerventil 37 in der vorher beschriebenen Weise umgesteuert wird.

In den Fig. 4 und 5 ist das Steuerventil 29 in seinen

0141305

beiden Schaltstellungen dargestellt. Ein quaderförmiger Ventilkörper ist mit Hilfe einer Schraube 57 mit der Grundplatte 3 verschraubt und durch einen Zentrierstift 58 gegen Verdrehen gesichert. Die untere Seite ist im Bereich der Abtastplatte 30 zurückgesetzt, so daß sich dort ein Spalt 59 ergibt, in den sich die Abtastplatte 30 frei bewegen kann. Der Ventilkörper 56 enthält eine Bohrung mit einem, zumindest im Oberteil angebrachten, Gewinde 60, in das die Schlauchleitung 31 eingeschraubt ist. Die Schlauchleitung 31 ist aus üblichem Kunststoffmaterial und ist durch den Einschraubvorgang fest mit dem Ventilkörper 56 verbunden. Je nachdem, wie weit die Schlauchleitung 31 eingedreht wird, kann die Höhe der unteren Kante 61 der Schlauchleitung 31 in der Höhe eingestellt und justiert werden. Diese Kante 61 dient, wie weiter unten ausgeführt wird, als Ventilsitz. Die Abtastplatte 30 wird von einem Stift 62 getragen, der in einen rohrförmigen Ventileinsatz 63 ragt. Im Ventileinsatz 63 ist eine Feder 64 angeordnet, die den Stift 62 in seine untere Endlage gegen einen Anschlag drängt. Der Ventileinsatz 63 steckt von unten her locker in der Schlauchleitung 31, so daß durch einen Spalt Druckluft (Pfeile 65) austreten kann. Der Ventileinsatz 63 trägt an seiner Unterseite eine Verdickung 66 mit einer oberen, konisch angestellten Schulter 67. Die Verdickung ist so groß, daß sie noch locker unter Bildung eines Spalts in der Bohrung im Ventilkörper 56 sitzt und hin- und herbewegbar ist, jedoch im Durchmesser größer als der innere Durchmesser der Schlauchleitung 31 ist. Der Ventileinsatz 63 und damit der Stift 62 mit der Abtastplatte 30 sind lediglich von unten her in den Ventilkörper 56 vor dessen Verschraubung mit der Grundplatte 3 eingesteckt und durch das Herausfallen nach oben hin durch den geringeren Schlauchdurchmesser des Schlauches 31 und nach unten hin durch den Ansatz 68 in der Grundplatte 3 gesichert.

In Fig. 4 ist die Stellung gezeigt, wenn das Ventil 29 offen ist. Die Schlauchleitung 31 wird so weit im Gewinde 60 eingeschraubt, daß noch ein ausreichend großer Spalt zwischen der Verdickung 66 und der Kante 61 verbleibt, durch den Druckluft abströmen kann. Die Abtastplatte 30 und damit der Ventileinsatz 63 werden entweder durch die Gravitationskraft nach unten gezogen oder von der anstehenden Druckluft in Richtung Offenstellung geschoben. Im vorliegenden Fall ist dann das Steuerventil 37 in der in Fig. 1 gezeichneten Stellung und der Federbügel 9 nach unten verfahren.

In Fig. 5 ist der Stecker 2 bereits eingesteckt und dadurch die Abtastplatte 30 angehoben. Bei der Bewegung nach oben bleibt vorerst die Feder 64 in ihrer gestreckten Lage, wodurch die Verdickung 66 bzw. die konische Schulter 67 nach oben an die Unterkante 61 der Schlauchleitung 31 geführt wird und dort anliegt. Dadurch ist die Schlauchleitung 31 abgedichtet. Es ist hier kein Gummring oder ähnliches erforderlich, da zur dichten Verbindung die elastischen Eigenschaften der Kunststoffschlauchleitung 31 herangezogen werden. Die Dichtung wird durch die konische Form der Schulter 67 verbessert. Die Verdickung 66 kommt jedoch bereits nach einem sehr kurzen Weg zur Anlage an der Kante 61. Durch die Absperrung der Schlauchleitung 31 wird das Steuerventil 37 umgesteuert und dadurch der Schalter 2 vom Federbügel 9 gepackt und weiter nach oben gezogen, wodurch auch die Abtastplatte 30 weiter nach oben geführt wird. Dies ist dadurch möglich, daß der Stift 62 federnd gelagert ist und in Zugrichtung überdrückt werden kann. Durch diese Möglichkeit der Überdrückung braucht die Justage des Ventils nicht genau zu sein, da lediglich der Überdrückungsbereich erreicht werden muß.

Das in Fig. 4 und 5 gezeigte Ventil ist äußerst einfach aufgebaut, da als Dichtelement die ohnehin vorhandene Schlauchleitung mitverwendet wird. Zudem kann ein solches Ventil, wie auch im vorliegenden Anwendungsfall erforderlich, äußerst klein und platzsparend aufgebaut werden. Es könnte beispielsweise an Stelle des quaderförmigen Ventilkörpers 56 direkt eine handelsübliche Schlauchverschraubung oder Schnellkupplung verwendet werden, in die der Ventileinsatz 63 eingeschoben ist. Es handelt sich hier um eine Art pneumatischen Endschalter, der durch die Möglichkeit der Überdrückung zum einen nicht genau justiert werden braucht und andererseits, wie im vorliegenden Fall, direkt im Stellweg einer pneumatischen Steuerung mitangebracht werden kann. Es sind somit, losgelöst vom vorliegenden Anwendungsbeispiel, eine große Zahl von Anwendungsfällen in pneumatischen Steuerungen denkbar, bei denen es auf eine Miniaturisierung ankommt, so daß dem Steuerventil eigenständige Bedeutung beikommt.

Zusammenfassend wird festgestellt, daß mit dem Anmeldungsgegenstand eine Halte- und Abtastvorrichtung aufgezeigt wird, die allen Forderungen der Praxis bei der Prüfung von Kabeln und Kabelbäumen genügt.

Herr

Hans Hackner

Wappersdorf Nr. 35

8431 Mühlhausen/Opf.

Fauststraße 30
D-8070 Ingolstadt

Telefon (08 41) 7 24 12
Telegramm neupat Ingolstadt
Telex 5 5809 nepa d

P 59HA 84/54

Patentansprüche

1. Halte- und Abtasteinrichtung für einen elektrischen Stecker

mit einer Grundplatte und einer darin enthaltenen Aussparung zum Einführen des Steckers,

mit einer Einrichtung zum Festhalten des in die Aussparung eingeführten Steckers, die über eine Abfühleinrichtung beim Einführen des Steckers elektrisch oder pneumatisch betätigt wird und mit einer Betätigungseinrichtung zur nachfolgenden Freigabe des Steckers,

dadurch gekennzeichnet,

daß die Einrichtung zum Festhalten des Steckers ein Federbügel (9) mit zwei federnden Schenkeln (20, 21) ist,

wobei die Schenkel (20, 21) wenigstens einen von der Aussparung (14) aus gesehen konisch nach innen weisenden Bereich enthalten, der sich an festen Führungen (24, 25) abstützt, die Schenkel (20, 21) an ihren Enden im Bereich der Aussparung (14) Kralleinrichtungen (22) enthalten und

der Federbügel (9) in Richtung der Steckereinführung durch einen von der Abfühleinrichtung (30) durch eine die Abfühleinrichtung enthaltende Steuereinrichtung (7) aktivierbaren Antrieb (6) bewegbar ist, so daß ein bereits teilweise eingeführter Stecker (2) wegen der konischen Schenkelführung durch die Kralleinrichtung ergriffen und in die Aussparung (14) automatisch völlig eingezogen wird.

2. Halte- und Abtastvorrichtung nach Anspruch 1, dadurch gekennzeichnet, daß die Kralleinrichtung durch eine Biegung der Schenkel (20, 21) auf die Aussparung (14) zu und Ausformung zu Spitzen (22) gebildet ist.

3. Halte- und Abtastvorrichtung nach Anspruch 1 oder 2, dadurch gekennzeichnet, daß der Antrieb (6) elektrisch, insbesondere als Tauchspule ausgeführt ist und die Abfühleinrichtung (30) ein elektrischer Endschalter ist.

4. Halte- und Abtastvorrichtung nach Anspruch 1 oder 2, dadurch gekennzeichnet, daß der Antrieb (6) eine pneumatische, doppelwirkende Kolben-Zylinder-Einheit (6) ist.

5. Halte- und Abtastvorrichtung nach einem der Ansprüche 1, 2 oder 4, dadurch gekennzeichnet, daß die Abfühleinrichtung (30) aus einem ersten Steuerventil (29) besteht mit einer Abtastplatte (30), die im Bereich der Aussparung (14) angebracht ist und beim Einführen des Steckers zum Schließen des Steuerventils bewegt wird, die Steuereinrichtung (7) weiter aus einem zweiten Steuerventil (34) besteht, das geschlossen ist und durch Handbetätigung öffenbar ist und aus einem dritten Steuerventil (37) besteht mit zwei schaltbaren Wegen (38, 43), die mit den Eingängen (40, 41) der Kolben-Zylinder-Einheit (6) verbunden sind, wobei die Leitungen vom ersten und zweiten Steuerventil (29, 34) auf den Steuereingang des dritten Steuerventils (37) geschaltet sind.

6. Halte- und Abtastvorrichtung nach Anspruch 5, dadurch gekennzeichnet, daß das erste Steuerventil (29) aus einem Ventilkörper (56) besteht mit einer Bohrung, in der eine Schlauchleitung (31) gehalten ist, daß in die Schlauchleitung (31) ein Ventileinsatz (63) eingeschoben ist, der locker unter Bildung eines Spalts in der Schlauchleitung (31) sitzt, der rohrförmig ausgebildet ist und der eine Feder (64) enthält, daß der Ventileinsatz (63) endseitig eine Verdickung (66) aufweist, die im Durchmesser größer als der Innendurchmesser der Schlauchleitung (31) ist, jedoch kleiner als der Durchmesser der Bohrung im Ventilkörper (56) ist, daß ein Taststift (62), der gegebenenfalls mit einer Tastplatte (30) versehen sein kann, gegen die Kraft der Feder (64) im Ventileinsatz (63) verschiebbar ist, so daß ein Absperrventil vorliegt, das bei Betätigung des Taststifts (62) durch Anlage der Verdickung (66) an der Kante (61) der Schlauchleitung (31) dicht schließt und bei einer weiterführenden Betätigung des Taststifts (62) nicht blockiert, sondern gegen die Kraft der Feder (64) überdrückbar ist.

7. Halte- und Abtastvorrichtung nach Anspruch 6, dadurch gekennzeichnet, daß der Ventilkörper (56) eine handelsübliche Schlauchschraub- oder Schlauchsteckverbindung ist.

8. Halte- und Abtastvorrichtung nach Anspruch 6 oder 7, dadurch gekennzeichnet, daß die Verdickung (66) eine konisch angestellte, umlaufende und dem Schlauchende (61) zugewandte Schulter aufweist, die in der Schließstellung teilweise in die Schlauchleitung (31) eintaucht.

0141305

FIG.1

FIG. 2

FIG. 3

0141305

FIG. 4

FIG. 5